Europäisches Patentamt

European Patent Office

Office européen des brevets

(11) Veröffentlichungsnummer : **0 131 730**
**B1**

# (12) EUROPÄISCHE PATENTSCHRIFT

(45) Veröffentlichungstag der Patentschrift :
06.05.87

(51) Int. Cl.⁴ : **B 23 K   1/08**

(21) Anmeldenummer : **84106314.2**

(22) Anmeldetag : **02.06.84**

(54) **Verfahren zum Schutz der Oberfläche eines Lötbades.**

(30) Priorität : **15.07.83 CH 3898/83**

(43) Veröffentlichungstag der Anmeldung :
**23.01.85 Patentblatt 85/04**

(45) Bekanntmachung des Hinweises auf die Patenterteilung : **06.05.87 Patentblatt 87/19**

(84) Benannte Vertragsstaaten :
**AT BE DE FR GB IT LU NL SE**

(56) Entgegenhaltungen :
**DE-A- 2 639 158**
**FR-A- 2 341 393**
**US-A- 3 752 383**

(73) Patentinhaber : **LGZ LANDIS & GYR ZUG AG**
**CH-6301 Zug (CH)**

(72) Erfinder : **Stratil, Tomas**
**Goldermattstrasse 22**
**CH-6312 Steinhausen (CH)**
Erfinder : **Pisinger, Milos**
**Seefeldstrasse 194**
**CH-8008 Zürich (CH)**
Erfinder : **Fehr, Peter**
**Bohlstrasse 20**
**CH-6300 Zug (CH)**

(74) Vertreter : **Müller, Hans-Jürgen, Dipl.-Ing. et al**
**Müller, Schupfner & Gauger Lucile-Grahn-Strasse 38**
**Postfach 80 13 69**
**D-8000 München 80 (DE)**

## Beschreibung

Die Erfindung bezieht sich auf ein Verfahren zum Schutz der Oberfläche eines Lötbads und zur Entfernung von Metalloxiden nach dem Oberbegriff des Patentanspruchs 1.

Beim maschinellen Weichlöten von Leiterplatten hängt die rationelle Fertigung weitgehend von einem einwandfreien Lötbad ab. Um die Oberfläche des Lötbads möglichst vor Oxydation zu schützen und die vom Flussmittel gelösten und die vornehmlich in der Lötwelle entstandenen Oxydationsprodukte des flüssigen Lots zu entfernen, hat man Abdeckmittel für das Lötbad in Form einfacher Fatte, pflanzlicher oder mineralischer Oele, ölförmiger Ester oder in Mineralöl gelöster organischer Säuren verwendet. Solche Verfahren sind aus DE-A1-2 639 158 bekannt. Die Wirksamkeit dieser bekannten Abdeckmittel auf den Herstellungsvorgang ist jedoch unbefriedigend, da sie entweder nach kurzem Gebrauch verdicken, so dass sie nicht mehr verwendet werden können, oder die Lötmaschinen mit harzartigen Rückständen verunreinigen. Deshalb müssen die Abdeckmittel in kurzen Zeitabständen erneuert werden, und der Reinigungsaufwand ist sehr gross.

Der Erfindung liegt die Aufgabe zugrunde, ein Verfahren zum Schutz der Oberfläche eines Lötbads und zur Entfernung von Metalloxiden nach dem Oberbegriff des Patentanspruchs 1 zu schaffen, durch welches die Standzeit des Abdeckmittels wesentlich verlängert und Material-, Reinigungs und Pflegekosten für die Lötmaschinen sowie entsprechende Arbeits- und Totzeiten vermindert werden können.

Die Aufgabe wird durch die Merkmale des Kennzeichens des Patentanspruchs 1 gelöst. Die Lösung weiterer Teilaufgaben ist in den restlichen Ansprüchen angegeben.

Durch eine gegenüber den bekannten Abdeckmitteln um ein Mehrfaches verlängerte Standzeit des Abdeckmittels, durch Einsparungen an Material und Zeit für die Erneuerung des Abdeckmittels, durch Abwesenheit von harzartigen Ablagerungen in der Lötmaschine und durch Vermeidung einer wesentlichen Viskositätssteigerung des Abdeckmittels im Verlauf seiner Verwendung ist das erfindungsgemässe Verfahren sehr wirtschaftlich.

Das Verfahren wird anhand einer Zeichnung näher erläutert.

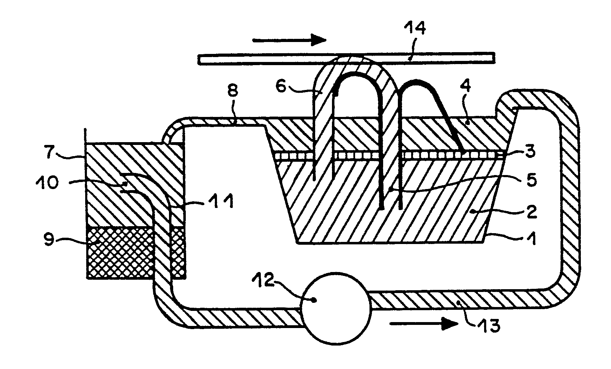

Die einzige Figur der Zeichnung zeigt schematisch eine Lötmaschine, bestehend aus einem Behälter 1 für ein Lot 2 und ein aus einer unteren Phase 3 und einer oberen Phase 4 zusammengesetztes Abdeckmittel für das Lot 2, einem mit einer nichtgezeichneten Pumpe verbundenen kanal 5 zur Erzeugung einer Lötwelle 6 und einem Sammelbehälter 7. Mittels eines in einiger Entfernung über der Grenze der unteren Phase 3 des Abdeckmittels angeordneten Ueberlaufs 8 kann die obere Phase 4 des Abdeckmittels in den Sammelbehälter 7 überlaufen. Am Boden des Sammelbehälters 7 ist ein Raum 9 zum Sammeln von beim Löten entstandenen Metallseifen vorgesehen. Darüber ist die Oeffnung 10 eines Rohres 11 angebracht, durch welches mittels einer Pumpe 12 und eines in den Behälter 1 zurückführenden Rohres 13 die obere Phase 4 umgewälzt wird. Auf der Lötmaschine wird eine Leiterplatte 14 gelötet.

Im Behälter 1 ist eine nichtgezeichnete Heizvorrichtung zur Erwärmung des Lotes 2 angeordnet, durch welche dieses auf eine Löttemperatur von beispielsweise 250 C aufgeheizt wird. Zum Schutz des flüssigen Lots 2 und zur Entfernung von dessen Oxydationsprodukten ist dieses mit der bei Zimmertemperatur festen, bei der Temperatur des flüssigen Lots 2 dagegen flüssigen unteren Phase 3 und mit der flüssigen oberen Phase 4 des Abdeckmittels überschichtet.

Beim erfindungsgemässen Verfahren sind die Phasen 3 und 4 des Abdeckmittels voneinander getrennt. Die Bestandteile der beiden Phasen 3 und 4 sind ineinander unlöslich. Die untere Phase 3 hat ein höheres spezifisches Gewicht als die obere Phase 4.

Die untere Phase 3 des Abdeckmittels besteht aus einer chemisch aktiven Komponente mit niedrigem Dampfdruck, welche imstande ist, Metalloxide des zu lötenden Metalls und insbesondere des Lots 2 zu binden. Dazu eignen sich organische Säuren, allein oder in Mischung, oder deren Ester, insbesondere Sebacin- oder Korksäure. Diese werden in einer genügenden Menge angewendet, so dass die Oberfläche des Lots 2 vollständig mit einer zusammenhängenden Schicht bedeckt ist. Zu diesem Zwecke genügt die allenfalls zusammen mit dem Flussmittel eingebrachte und unverbrauchte Korksäure nicht. Daher muss der Hauptanteil der Phase 3 separat in das Abdeckmittel eingetragen werden.

In der oberen Phase 4 des Abdeckmittels wird ein mit der unteren Phase 3 nicht vermischbarer, temperaturbeständiger Kohlenwasserstoff, vorzugsweise ein synthetisches flüssiges Polyalphaolefin verwendet, das keine Neigung zur Bildung harzartiger Ablagerungen aufweist.

Beispiel

Für die maschinelle Lötung von Leiterplatten 14 wird die beschriebene Wellenlötmaschine nach dem Schema der Zeichnung verwendet. Das im Behälter 1 vorhandene Lot 2 wird vorzugsweise mit einem synthetischen flüssigen Polyalphaolefin bis zum Ueberlauf 8 überschichtet, das sehr alterungsbeständig ist und einen niedrigen Dampfdruck aufweist. Gleichfalls wird der Sammelbehälter 7 bis zu einem vorbestimmten Niveau aufgefüllt. In das Polyalphaolefin wird pulverförmige Sebacin- und/oder Korksäure oder deren Ester in einer vorbestimmten Menge haufenweise aufgeschüttet. Die Säureverbindung schmilzt und bildet eine geschmolzene Schicht als deutlich von dem die obere Phase 4 bildenden Polyalphaolefin abgesetzte Phase 3 auf dem Lot 2. Durch den über der Oberfläche der unteren Phase 3 angebrachten Ueberlauf 8 ist dafür gesorgt, dass während des ganzen darauf folgenden Lötprozesses nur die obere Phase 4 mittels der Pumpe 12 über die Rohre 11 und 13 vom und zum Behälter 1 umgewältzt wird.

Die obere Phase 4 wirkt nur als Trennmittel von der Luft und als Oxydationsschutz für das flüssige Lot 2. Durch den niedrigen Dampfdruck dieser Phase 4 ist die Rauchbildung und der Verdampfungsverlust sehr gering.

Die zugegebene oder aus dem entsprechenden Ester in der Wärme abgespaltene organische Säure der unteren Phase 3 des Abdeckmittels als chemisch aktive Komponente entfernt in der Lötwelle entstandene Oxide unter Verseifung. Die dadurch entstehenden Metallseifenpartikel sind in der oberen Phase 4 des Polyalphaolefins nicht löslich. Sie werden aber von dieser Phase 4 beim Umpumpen mitgerissen und setzen sich infolge ihres höheren spezifischen Gewichts im Raum 9 des Sammelbehälters 7 in Bodennähe ab. Das mittels der Oeffnung 10 des Rohres 11 dekantierte Polyalphaolefin wird mittels der Pumpe 12 über das Rohr 13 in den Behälter 1 mit dem Lot 2 zurücktransportiert.

Das Abdeckmittel der unteren Phase 3 wird nach Massgabe des Verbrauchs 2 periodisch, z. B. zweimal pro Woche ergänzt. In einer Woche muss bei normalem Betrieb der Lötmaschine 40 bis 80 g des Pulvers aufgewendet werden. Das gesamte Abdeckmittel wird nach 1 1/2 bis 3 Monaten als Ganzes ausgewechselt, was eine 5- bis 10-fache Erhöhung der Standzeit gegenüber bekannten Abdeckmitteln bedeutet. Es entstehen praktisch keine harzartigen Ablagerungen auf der Lötmaschine. Die Verdampfungsverluste und die Geruchsbelästigungen sind minimal. Auch der zeitliche Aufwand für die Reinigung und Pflege der Lötmaschine ist gering. Als Folge der erheblich höheren Standzeit sind die Materialkosten im Vergleich zu bekannten Abdeckmitteln wesentlich kleiner.

**Patentansprüche**

1. Verfahren zum Schutz der Oberfläche eines Lötbads und zur Entfernung von Metalloxiden beim maschinellen Weichlöten von Schwermetallen, mit einem bei Löttemperatur flüssigen Abdeckmittel, dadurch gekennzeichnet, dass das Abdeckmittel aus zwei übereinander angeordneten, bei Löttemperatur flüssigen Phasen (3, 4) besteht, wobei die untere Phase (3) ein höheres spezifisches Gewicht als die obere Phase (4) hat.

2. Verfahren nach Anspruch 1, dadurch gekennzeichnet, dass man ein Abdeckmittel mit zwei ineinander unlöslichen Phasen (3, 4) verwendet.

3. Verfahren nach Anspruch 2, dadurch gekennzeichnet, dass die beiden Phasen (3, 4) einen niedrigen Dampfdruck aufweisen.

4. Verfahren nach Anspruch 2, dadurch gekennzeichnet, dass man ein Pulver einer bei Zimmertemperatur festen, bei Löttemperatur flüssigen chemisch aktiven Komponente für die untere, mit dem Lötbad unmittelbar in Berührung stehende Phase (3) auf die obere Phase (4) haufenweise aufschüttet.

5. Verfahren nach Anspruch 4, dadurch gekennzeichnet, dass man eine genügende Menge einer aus organischen Säuren oder Estern, vorzugsweise Sebacin- und/oder Korksäure oder deren Estern bestehende chemisch aktive Komponente verwendet, so dass diese als untere Phase (3) das Lot (2) überdeckt.

6. Verfahren nach Anspruch 5, dadurch gekannzeichnet, dass man bei Verwendung von Korksäure einen kleineren Anteil als Trägerkomponente in einem Flussmittel und einen grösseren Anteil durch Aufschütten des Pulvers in die Phase (4) einbringt.

7. Verfahren nach Anspruch 2, dadurch gekennzeichnet, dass man als obere Phase (4) im Abdeckmittel ein flüssiges synthetisches Polyalphaolefin verwendet.

8. Verfahren nach Anspruch 2, dadurch gekennzeichnet, dass man durch einen in einem Abstand von der Oberfläche der unteren Phase (3) angeordneten Ueberlauf (8) nur die obere Phase (4) des Abdeckmittels zirkulieren lässt.

9. Verfahren nach Anspruch 1, dadurch gekennzeichnet, dass man durch eine über der Oberfläche im Absetzraum (9) eines Sammelbehälters (7) angeordnete Oeffnung (10) dafür Sorge trägt, dass von der umgepumpten Phase (4) mitgerissene Metallseifenpartikel sich im Sammelbehälter (10) absetzen.

**Claims**

1. A method of protecting the surface of a solder bath and removing metal oxides in the mechanised soft soldering of heavy metals, with a cover agent which is liquid at soldering temperature, characterised in that the cover agent comprises two phases (3, 4) which are liquid at soldering temperature and which are arranged one above the other, wherein the lower phase (3) is of higher specific weight than the upper phase (4).

2. A method according to claim, characterised by using a cover agent comprising two phases (3, 4) which are insoluble in each other.

3. A method according to claim 2, characterised in that the two phases (3, 4) have a low vapour pressure.

4. A method according to claim 2, characterised in that a powder of a chemically active component which is solid at room temperature and liquid at soldering temperature, for constituting the lower phase (3) which is in direct contact with the solder bath, is deposited heapwise on the upper phase (4).

5. A method according to claim 4, characterised by using a sufficient amount of a chemically active component which comprises organic acids or esters, preferably sebacic and/or suberic acid or esters thereof. so that said chemically active component, as the lower phase (3), covers over the solder (2).

6. A method according to claim 5, characterised in that when using suberic acid, a smaller proportion is introduced in the form of a carrier component in a fluxing agent and a larger proportion is introduced by depositing the powder into the phase (4).

7. A method according to claim 2, characterised in that a liquid synthetic polyalphaolefin is used as the upper phase (4) in the cover agent.

8. A method according to claim 2, characterised in that only the upper phase (4) of the cover agent is circulated by an overflow (8) arranged at a spacing from the surface of the lower phase (3).

9. A method according to claim 1, characterised in that an opening (10) arranged above the surface in the settlement space (9) of a collecting container (7) provides that metal soap particles which are entrained by the pump-circulated phase (4) are deposited in the collecting container (10).

**Revendications**

1. Procédé pour protéger la surface d'un bain de soudure et pour enlever les oxydes métalliques lors d'une soudure douce à la machine de métaux lourds, à l'aide d'un moyen de recouvrement liquide à la température de soudure, caractérisé en ce que le moyen de recouvrement se compose de deux phases (3, 4) liquides à la température de soudure, placées l'une au-dessus de l'autre, la phase inférieure (3) ayant un poids spécifique plus grand que celui de la phase supérieure (4).

2. Procédé selon la revendication 1, caractérisé en ce qu'on utilise un moyen de recouvrement comportant deux phases (3, 4) insolubles l'une dans l'autre.

3. Procédé selon la revendication 2, caractérisé en ce que les deux phases (3, 4) ont une faible pression de vapeur.

4. Procédé selon la revendication 2, caractérisé en ce qu'on verse de façon fractionnée sur la phase supérieure (4) une poudre d'un composant chimiquement actif, solide à la température ambiante et liquide à la température de soudure, de la phase inférieure (3), directement en contact avec le bain de soudure.

5. Procédé selon la revendication 4, caractérisé en ce qu'on utilise une quantité suffisante d'un composant chimiquement actif, constitué d'acides organiques ou d'esters, de préférence d'acides sébacique et/ou subérique ou leurs esters, de telle sorte que ce composant recouvre la soudure (2) comme phase inférieure (3).

6. Procédé selon la revendication 5, caractérisé en ce que, lors d'utilisation d'acide subérique, on en utilise une petite proportion comme composant de support dans un flux et une grande proportion par versement de la poudre dans la phase (4).

7. Procédé selon la revendication 2, caractérisé en ce que l'on utilise dans le moyen de recouvrement comme phase supérieure (4) une polyalphaoléfine synthétique liquide.

8. Procédé selon la revendication 2, caractérisé en ce qu'on laisse passer dans un trop-plein (8), déposé à distance de la surface de la phase inférieure (3), seulement la phase supérieure (4) du moyen de recouvrement.

9. Procédé selon la revendication 1, caractérisé en ce que, au moyen d'une ouverture (10) disposée au-dessus de la surface du volume de dépôt (9) d'un récipient collecteur (7), on fait en sorte que des particules de savon métallique entraînées par la phase (4) en circulation se déposent dans le récipient collecteur (10).